Europäisches Patentamt

(19) European Patent Office

Office européen des brevets

(11) Publication number: **0 117 259**
**B1**

(12) # EUROPEAN PATENT SPECIFICATION

(45) Date of publication of patent specification: **06.05.87**

(51) Int. Cl.[4]: **G 01 R 31/26**

(21) Application number: **83101789.2**

(22) Date of filing: **23.02.83**

(54) **A method for determining charged energy states of semiconductor or insulator materials by using deep level transient spectroscopy, and an apparatus for carrying out the method.**

(43) Date of publication of application:
**05.09.84 Bulletin 84/36**

(45) Publication of the grant of the patent:
**06.05.87 Bulletin 87/19**

(84) Designated Contracting States:
**AT BE CH DE FR GB IT LI LU NL SE**

(56) References cited:
**EP-A-0 041 858**

**IEEE TRANSACTIONS ON ELECTRON DEVICES, vol. ED-27, no. 12, December 1980, New York, M.D. JACK et al. "A computer-controlled deep-level transient spectroscopy system for semiconductor process control", pages 2226-2231**

**REVIEW OF SCIENTIFIC INSTRUMENTS, vol. 53, no. 2, February 1982, New York, K. KOSAI "External generation of gate delays in a boxcar integrator - application to deep level transient spectroscopy", pages 210-213**

**JOURNAL OF PHYSICS E - SCIENTIFIC INSTRUMENTS, vol. 14, no. 3, March 1981, Dorking, B. BALLAND et al. "X-Y plotter capacitance meter interface for deep level spectroscopy", pages 367-372**

(73) Proprietor: **Magyar Tudományos Akadémia Müszaki Fizikai Kutato Intézete**
**Foti ut 56.**
**H-1047 Budapest IV. (HU)**

(72) Inventor: **Ferenczi, György**
**Ormodi u. 12/a**
**H-1124 Budapest (HU)**
Inventor: **Boda, János**
**Martos Flora u. 5/a**
**H-1148 Budapest (HU)**
Inventor: **Toth, Ferenc**
**Kelenhegyi u. 46/a**
**H-1118 Budapest (HU)**
Inventor: **Horváth, Péter**
**Nagytétényi u. 246**
**H-1225 Budapest (HU)**
Inventor: **Benkovics, László**
**Ferenc u. 8**
**H-2120 Dunakeszi (HU)**
Inventor: **Dozsa, László**
**Kakukk u. 28**
**H-2030 Erd (HU)**

(74) Representative: **Patentanwälte Viering & Jentschura**
**Steinsdorfstrasse 6**
**D-8000 München 22 (DE)**

Courier Press, Leamington Spa, England.

(56) References cited:

**JOURNAL OF PHYSICS E - SCIENTIFIC INSTRUMENTS, vol. 14, no. 4, April 1981, Dorking, L. JANSSON et al. "A sensitive and inexpensive signal analyser for deep level studies", pages 464-467**

**APPLIED PHYSICS, vol. 12, 1977, H. LEFEVRE et al. "Double correlation technique (DDLTS) for the analysis of deep level profiles in semiconductors", pages 45-53**

**SOLID-STATE ELECTRONICS, vol. 24, 1981, C.R. CROMWELL et al. "Transient distortion and nTH order filtering in deep level transient spectroscopy (DnLTS), pages 25-36**

## Description

The invention relates to a method for determining charged energy states of semiconductor or insulator materials by using deep level transient spectroscopy called widely as DLTS technique.

The invention relates also to an apparatus for carrying out a method which can perform DLTS measurements.

The determination of charged energy states of semiconductor and insulator materials, especially of oxide layers on semiconductors forms a basic task of semiconductor research and production, since the energy states (the deep levels) substantially determine the properties of semiconductor devices. The first widely accepted method for the quick examination of deep levels was proposed by D. V. Lang (J.Appl.Phys. *45*, pp. 3023—3032, 1974) and he called his method as deep level transient spectroscopy or in short as DLTS method. This method was used in its first implementation for detecting transient capacitances, and later B. W. Wessel proposed (J.Appl. Phys. *47*, pp. 1131—1133, 1976) the DLTS measurement of current transients. The principal identity of these two methods was disclosed by J. A. Borsuk and R. M Swansen (IEEE Trans. Electron. Dev. *ED-27*, pp. 2217—2225, 1980), and it was stated that depending on certain material properties one or other of these method might offer relative advantages.

In the original Lang method a double boxcar intergator was used for averaging the transient signals. For the improvement of this method L. C. Kimerling (IEEE Trans. Nucl. Sci. *NS-23*, 1976) proposed first the usage of a lock-in amplifier for signal averaging. In principle the lock-in amplifier can provide a better signal to noise ratio, however, in the particular application suggested by that paper its accuracy and reliability has not yet been satisfactory. The analysis of the problems was disclosed by D. S. Day et al. (J. Appl. Phys. *50*, pp. 5093—5096, 1979).

For increasing the accuracy a specifial timing and the usage of a wideband synchronous detector (lock-in amplifier) has been proposed by the present applicant in EP—A—0041858.

In order that the measurements carried out with different repetition frequencies be comparable with each other, phase-adjustment is used which is independent of the repetition frequency of the exciting pulses. The passage of the measuring signal is blocked during the existance of the exciting pulses and of a subsequent dead period corresponding to a frequency-independent phase-angle, and the squarewave of the lock-in amplifier is synchronized to the terminating moments of the dead periods. The length of the dead period is adjusted dependent on the time required for the decaying of the switching transients of the measuring unit. According to the considerations disclosed in that publication the length of the dead period had to be about fifteen-times greater than the response time of the measuring unit (detector), because in such a period the transients would decay to $10^{-5}$ times of the original value. The required accuracy could be reached by such a long waiting time only.

If it is taken into account that the duration of switching transients (the response time of the detector) is typically 5 µs, then the minimum value for the dead period is 75 µs. For obtaining the required accuracy the combined duration of an exciting pulse and of a dead period can not be longer than 10% of the period time of the exciting pulses. Therefore the period time of the exciting pulses can not be shorter than 750 µs even if indefinitely short exciting pulses are chosen. With practical pulse-lengths the minimum repetition period time was about 1 ms. Due to practical considerations, the period time of the exciting pulses can not be longer than about 1 s, and with these limit values the possible range of adjustment of the period time of the exciting pulses will not be greater than three decimal orders of magnitude. This range of adjustment is required for determining the temperature dependence of activation energy. For widening the scale of measurements the increase of this range of adjustment has an outstanding significance.

A different method has been proposed by M. Schultz and H. Lefevre in DE—C—2631783 (Appl. Phys. *12*, pp. 45—53, 1977) which can be regarded as a special improvement of the averaging by a boxcar amplifier and this is called as double correlation DLTS method or in short as DDLTS method. The essence of the double correlation DLTS method of Schultz et. al. lies in the application of two exciting pulses with different shapes, and following these exciting pulses respective samples are taken in two different moments from the transient capacitance signals by using the well known Lang's method. The sign of the sampling pulses are different and the sign-order is inverse following the respective exciting pulses.

In contrast to the original Lang method the DDLTS technique is less sensitive against DC offset drifts and it facilitates the determination of the profile of the spatial distribution of deep levels. The comparison of various correlation methods has been disclosed by C. R. Cromwell et. al, in Solid State Electronics Vol. 24, pp. 25—36, 1981. It should be noted that for the implementation of the DDLTS method an apparatus is required which is different from those used for DLTS technique.

In the DDLTS method as proposed by Schultz et. al, the time windows used for the sampling pulses take only a small fraction of time elapsed between subsequent exciting pulses, and from this it follows that the signal to noise ratio of this method is less preferable. For performing double correlation specially designed multi-channel analog processing circuits are required. The application of a large number of analog circuits decreases the signal to noise ratio and in this way the sensitivity. With such an apparatus capacitance transients smaller than $10^{-3}$ pF can not be detected.

The object of the invention is to provide a method by which an increased signal to noise ratio and a higher sensibility can be reached during the usage of the DLTS technique and which enables- the performance of all examinations that have been limited to DDLTS technique so far.

A further object of the invention lies in the provision of a comparatively simple apparatus for carrying out the method.

According to the invention a method has been provided for determining charged energy states of a sample of a semiconductor or insulator material by using deep level transient spectroscopy, in which the sample is excited by the application of periodic exciting pulses to change the initial charge state thereof, and the transient response of the sample is detected as it returns to the thermodynamical balance condition following the termination of each of the excitation pulses, the detection is blocked during a blocking period defined by the occurrence of the exciting pulses and of a subsequent dead period including the recovery period of the means used for the detection, a weighted integration operation is performed on a detected response signal by the application of a symmetrical square wave synchronizing pulse as a weighting function synchronized to the frequency of the exciting pulses, in which, according to the invention, the detection is additionally blocked for the duration of a further blocking period including a dead period, the further blocking period beginning at a moment defined in mid-time between the starting moments of two subsequent exciting pulses, and the synchronizing pulses are synchronized to the terminating moments of the dead periods to have a repetition period which is equal to the repetition period of the periodic exciting pulses.

In accordance with the DLTS techniques in a measurement cycle the temperature of the sample is changed continuously with constant frequency of the exciting pulses, or the exciting frequency is changed with constant sample temperature.

By the method according to the invention the blocking periods and the transient processes associated therewith are generated with a double frequency compared to the frequency of the exciting pulses and of the weighting pulses. By means of the application of the specific weighting function defined hereinabove, the effects of the transient processes in the respective detecting half-periods offset each other which results in a number of advantages.

For ensuring the continuity of the detected response signal in the blocking periods the signal is substituted by a simulated signal for the weighted integration operation which has a value equal to that of the detected response signal immediately preceding the starting moment of the blocking period.

It is advantageous according to the invention if the sample is excited by second type exciting pulses during the further blocking periods occurring between the first exciting pulses, and the second type exciting pulses have a different intensity and/or duration than the first exciting pulses.

Resulting from the combined effect of the series of the first type exciting pulses and of the second type exciting pulses therebetween, not only the switching and blocking operations occur with double frequency relative to the weighting function but the exciting will also be doubled, however, the frequency of an exciting pulse series of a given type is always equal to that of the weighting function.

In this embodiment of the method a differential DLTS method is performed, which provides all examination possibilities that the DDLTS method does, however, with an increased sensitivity and with a less sophisticated instrumentation.

It is preferable if the length of the further blocking periods is adjusted to the combined duration of the second type exciting pulses and of the dead period, and the second type exciting pulses are synchronized to the synchronizing pulses in such a way that the terminating moments of the dead periods following each second type exciting pulse coincide with moments at which the sign of the synchronizing pulses is changed.

According to the invention an apparatus has also been provided for carrying out the method, in which the difference when compared to the apparatus according to EP—A—0041858, is that it comprises a frequency divider with a dividing ratio of 1:2 and the input of the divider is coupled to a control unit which delivers clock pulses synchronized to the end moments of the dead periods, the output of the divider is coupled to a reference input of a synchronous detector implemented preferably by a lock-in amplifier, and the control unit comprises an output coupled to an inhibiting input of the exciter to block the generation of every second exciting pulse.

For performing a differential DLTS method the exciter comprises a pair of pulse generators, the first pulse generator has inputs for receiving those outputs of the control unit which control the generation and inhibition of the first type exciting pulses, and the second pulse generator has an input for triggering the generation of the second type exciting pulses which is coupled to a further output of the control unit to determine the occurrence of the triggering moments.

The invention will now be described by preferable embodiments thereof, in which reference will be made to the accompanying drawings. In the drawings:

Fig. 1 shows the time diagrams of the various signals and pulses used during the method according to the invention, and

Fig. 2 shows the general block diagram of the apparatus according to the invention for carrying out the method.

According to the known DLTS technique a sample is taken from the semiconductor material which has to be examined, and the charge states of the energy levels of the sample are changed periodically. The periodic changing of the charge states can be achieved in different ways. If the sample is represented by p-n junction which is similar to a diode, then a voltage pulse can be used for excitation which decreases the reverse bias of the sample. The charge states of the sample can also be changed by the application of a current pulse that injects both types of carriers. Instead of a current pulse similar effects can be obtained by means of a light pulse or by the pulsated application of any other ionizing radiation (e.g. of an electron beam or of a gamma radiation) that can create electrons and holes in the sample.

During the presence of the exciting (injecting) pulses the capacitance of the sample or the current flowing therethrough will change substantially.

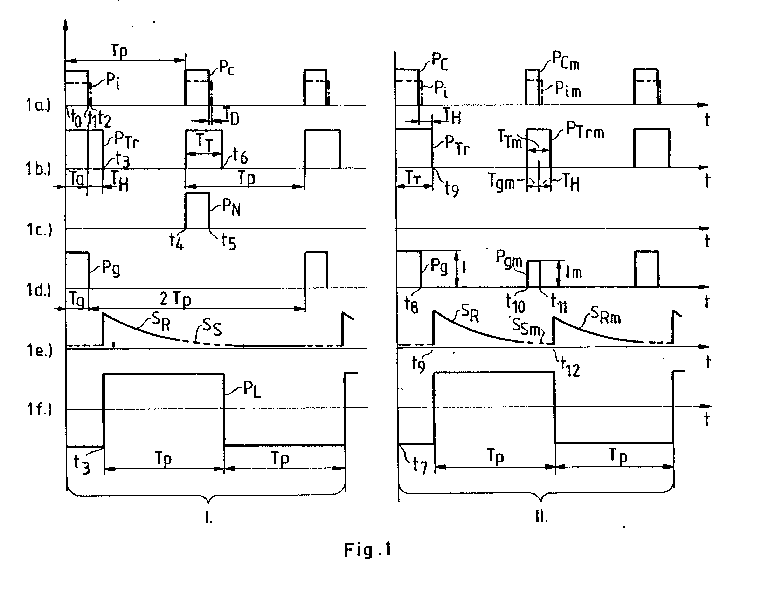

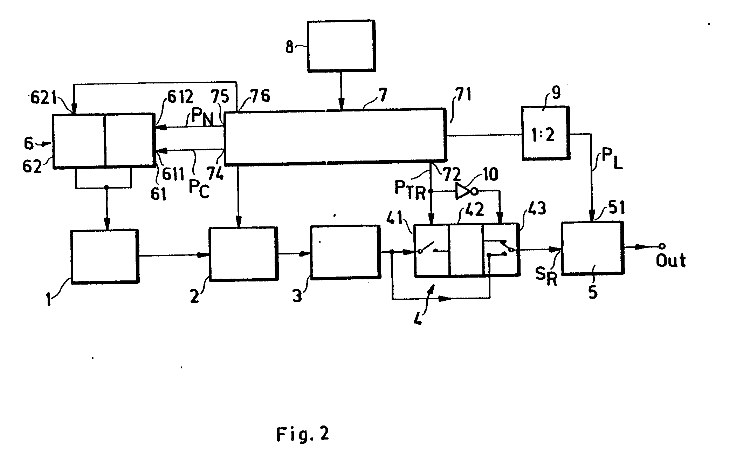

In order to be able to detect the response of the sample after the termination of the exciting pulse, the sample is coupled in a measuring circuit which is coupled to the input of a measuring unit. The measuring unit can be realized both by a capacitance meter and by a current meter. Fig. 2 shows the block diagram of this conventional arrangement which is complemented with some novel elements according to the invention. In the conventional part of Fig. 2 the measuring circuit 1 is coupled through a gating circuit 2 to the input of the measuring unit 3. The output of the measuring unit 3 is coupled through a transmission gate 4 to the input of a synchronous detector 5. The measuring circuit 1 is driven by an exciter 6. The operation of the exciter 6, of the gating circuit 2, of the transmission gate 4 and of the synchronous detector 5 is controlled by appropriate control pulses of a control unit 7 driven by a clock 8. The specific way of operation will be explained on the basis of time diagrams of Fig. 1. A more detailed description of the arrangement will be described subsequent to the discussion of the principles of operation.

Reference is made to Fig. 1 in which diagram 1a.) shows control pulses $P_c$ which control the operation of the exciter 6. The control pulses $P_c$ are used for the generation of exciting pulses $P_g$ shown in digram 1d.). The control pulses $P_c$ have a repetition period $T_p$ and each pulse has a duration $T_g$. The first control pulse $P_c$ is started at moment $t_0$ and it is terminated at moment $t_1$. The exciting pulses $P_g$ (diagram 1d.)) coincide with the control pulses $P_c$ i.e. they have respective durations $T_g$ and both their starting and terminating moments are identical with corresponding moments of the control pulses $P_c$. The difference between the exciting and control pulses $P_g$ and $P_c$ is that the repetition period of the exciting pulses $P_g$ is twice as long as that of the control pulses $P_c$. This means that every second control pulse $P_c$ can not generate a corresponding exciting pulse $P_g$.

Diagram 1c.) shows a blocking pulse $P_N$ that impedes the effect of the control pulse $P_c$ to generate an exciting pulse at moment $t_4$, whereby no exciting pulse will be started at the moment $t_4$. It should be emphasised that the blocking pulse $P_N$ has been illustrated as a separate pulse for the sake of better understanding only, since appropriate circuits can easily block the effect of every second control pulse $P_c$ to generate an exciting pulse, and there is no need for the actual application of the blocking pulses $P_N$.

In diagram 1a.) the dot-dash line illustrates isolating pulses $P_i$ which isolate the input of the measuring unit 3 from the output of the measuring circuit 1. The isolating pulses $P_i$, which control the gating circuit 2, substantially coincide with the control pulses $P_c$, and the difference is that their rear edges e.g. at the moment $t_2$ are slightly delayed with respect to the rear edges of the control pulses $P_c$ e.g. at the moment $t_1$. This delay is not more than some tenths of nanoseconds and it has the purpose of ensuring that the output of the measuring circuit 1 can be coupled to the input of the measuring unit 3 at moments (like $t_2$) when the corresponding exciting pulse $P_c$ is surely terminated (at moment $t_1$). The isolating pulses $P_i$ have a repetition period $T_p$ and the gating circuit 2 isolates the input of the measuring unit 3 from the measuring circuit 1 accordingly.

As it was explained before, the output of the measuring unit 3 is coupled through the transmission gate 4 to the input of the synchronous detector 5. The measuring unit 3 has a predetermined characteristic regeneration time $\tau$ (response time) which is typically in the range of some microseconds. When the measuring unit 3 is connected at the moment $t_2$ to the measuring circuit 1, a switching transient will occur in the output thereof. In order to prevent the average-formation process carried out by the synchronous detector 5 to be disturbed by this transient, the path between the output of the measuring unit 3 and the input of the synchronous detector 5 will be broken by means of blocking the signal passage through the transmission gate 4. This path-breaking occurs during a dead period $T_H$ following the termination of every control pulse $P_c$. Naturally the transmission gate 4 is blocked during the presence of the exciting pulse $P_g$, too. From this way of operation it follows that the duration $T_T$ of pulse $P_{Tr}$ controlling the blocking condition of the transmission gate 4 (diagram 1b.)) is defined by the equation; $T_T = T_g + T_H$.

The value of the dead period $T_H$ is chosen to be a predetermined constant portion of the repitition period $T_p$ as it is explained in EP—A—0041858 referred to hereinabove.

The terminating moment $t_3$ of the pulse $P_{Tr}$ will therefore be delayed by a constant phase angle relative to the terminating moment $t_1$ of the corresponding exciting pulse $P_g$ at any adjusted value of the repitition period $T_p$. According to a characteristic feature of the present invention the pulse $P_{Tr}$ is generated when a time equal to the repetition period $T_p$ has elapsed following the starting moment $t_0$, which pulse $P_{Tr}$ is adapted to block again the passage through the transmission gate 4.

Diagram 1e.) in Fig. 1 shows a gated response signal $S_R$ coupled through the transmission gate 4 to the input of the synchronous detector 5. At moment $t_3$ the transmission gate 4 is turned on and a decaying transient response signal is coupled to the input of the synchronous detector 5. This signal corresponds to the output of the measuring circuit 1 produced in response to the exciting pulse $P_g$ started at the moment $t_0$. At moment $t_4$ the passage through the transmission gate 4 is broken again for a duration $T_T$, and the corresponding isolating pulse $P_i$ releases the gating circuit 2 to disconnect the input of the measuring unit 3 from the measuring circuit 1. Apart from the fact that no exciting pulse is started at this moment $t_4$, all events are repeated at the moment $t_4$ which took place at the moment $t_0$.

In order to provide a continuously existing signal in the input of the synchronous detector 5 during the off-condition of the transmission gate 4, a track-and-hold or a sample-and-hold circuit is used for the storage of the last significant output of the transmission gate 4 preceding the moment $t_4$ and this stored signal is coupled during this off-period to the input of the synchronous detector 5. The dashed sections. in diagram 1e.) show this simulated value $S_s$ of the measuring signal.

The synchronous detector 5 has a reference input 51 which receives a symmetrical rectangular synchronizing pulse $P_L$ that is started at the moment $t_3$ and has a repetition period of $2T_p$. Under control of the synchronizing pulse $P_L$ the synchronous detector 5 provides the weighted integral of the measuring signal $S_R$ i.e. it subtracts the mean value generated in the negative period of the synchronizing pulse $P_L$ from the integral generated in the positive period thereof.

The above described way of operation elucidates a basic aspect of the present invention. Between the occurrence of two subsequent exciting pulses $P_g$ the switches of the measuring apparatus are operated with double periodicity. During the first operational period the processes which generate the switching transients occur substantially at the moments $t_2$ and $t_3$, which is followed by a positive average-forming process made by the synchronous detector 5. During the second operational period the switching transients occur about at the moments $t_5$ and $t_6$, which is followed by a negative average-forming by the synchronous detector 5. It is well-known in the art that the transient behavior of a measuring apparatus 2 triggered by a switching operation is defined by the properties of the apparatus and it is largely independent of the parameters of the measured signal. In a complete period of the synchronous detector 5 with the conditions illustrated diagrammatically in Fig. 1, the transient processes take place twice in sequence. The synchronous detector 5 averages the two corresponding responses with opposite signs, whereby the effects of the switching transients on the measurements will balance each-other.

The balanced effect of the switching transients results in a significant increase in zero-line stability and in addition to this increase, the length of the dead periods $T_H$ can be reduced substantially. The minimum dead period $T_H$ having to be about fifteen times longer than the regeneration time $\tau$ of the measuring unit in the apparatus described in EP—A—0041858, referred to hereinabove, to ensure that the switching transients can not exert a non-negligable influence on the measurements, it is sufficient in the present invention if the condition $T_H=\tau$ is met. Due to the substantial reduction of the dead period $T_H$, the range for adjustment of the repetition period $T_p$ will be increased from the earlier 3 orders of magnitude to 4.5 orders of magnitude, whereby the possibilities for carrying out the measurements are largely enhanced. The reduction of the dead period $T_H$ results in a corresponding increase in the actual detecting periods which is connected with increased sensibility.

The time-diagrams of Fig. 1 show a pair of regions I and II. The above described way of operation is characteristic to region I. The pulses shown between the moments $t_0$ and $t_6$ might go on repeatedly after the moment $t_6$.

Let us suppose that at moment $t_7$ which designates the beginning of the region II, the same pulses are generated as at the moment $t_0$ in region I. Thus, the moment $t_7$ corresponds to the moment $t_0$. Accordingly, in the region II the following pulses are provided: the control pulse $P_c$, the exciting pulse $P_g$ triggered by the control pulse, the isolating pulse $P_i$, the pulses $P_{Tr}$ for controlling the transmission gate 4, and in response to these pulses the response of the sample provides the response signal $S_R$ that controls the input of the synchronous detector 5. The exciting pulse $P_g$ is terminated at moment $t_8$ and it lasts for the duration $T_g$. This is followed by the dead period $T_H$ which is defined at moment $t_g$. The pulse $P_{Tr}$ lasts for the combined duration $T_T$ of the control pulse $P_c$ and the dead period $T_H$ i.e. till the moment $t_g$. The synchronizing pulse $P_L$ of the synchronous detector 5 is started at the moment $t_g$ and it has a period-time of $2T_p$.

Thus in region II similar events take place as in region I. The substantial functional difference is that a second type of control pulse $P_{Cm}$ is started at moment $t_{10}$ when a time of about $T_p$ has elapsed from the starting moment of the exciting pulse $P_g$, and the second control pulse $P_{Cm}$ has a duration of $T_{gm}$. The generation of the second control pulse $P_{Cm}$ is associated with the generation of a corresponding isolating pulse $P_{im}$, of a pulse $P_{Trm}$ for controlling the transmission gate 4 and of a second exciting pulse $P_{gm}$ differing in intensity and/or duration from the first exciting pulse $P_g$.

The conditions for the accurate timing should be established as follows. The second exciting pulse $P_{gm}$ is terminated at moment $t_{11}$. The pulse $P_{Trm}$ should be terminated at moment $t_{12}$ which occurs when a dead period $T_H$ has elapsed following the moment $t_{11}$, and the moment $t_{12}$ should coincide with the middle edge of the synchronizing pulse $P_L$ started at moment $t_g$ and having a repetition period of $2T_p$. The duration $T_{Tm}$ of the pulse $P_{Trm}$ is determined by the equation

$$T_{Tm} = T_{gm} + T_H,$$

in which $T_{gm}$ designates the duration of the second type exciting pulse $P_{gm}$. The starting moment $t_{10}$ for the second exciting pulse $p_{gm}$ should thus be set so as to precede the moment $t_{12}$, which has a fixed phase, by the combined duration of the dead period $T_H$ and the pulse duration $T_{gm}$.

In region II both the first and second types of the exciting pulses $P_g$ and $P_{gm}$ are generated periodically with respective periods of $2T_p$ so that their relative phase remains constant.

The second type of exciting pulses $P_{gm}$ differs in intensity and/or duration from the first type of exciting pulses $P_g$, and in the example illustrated in Fig. 1 its intensity $I_m$ is smaller and its duration is shorter than the corresponding parameters of the first type of exciting pulses $P_g$. From this it follows that the second response signals $S_{Rm}$ will be smaller than the first ones.

In region II the response signals $S_R$ and $S_{Rm}$ are repeated alternatively. The synchronous detector 5 is operated in the same way as in region I, therefore the weighted average-forming takes place just as it was described in connection with region I. The switching transients will again offset each other and result in the already described advantages. Owing the presence of the second type exciting pulses $P_{gm}$, however, the physical meaning of the output of synchronous detector 5 will now be different.

The suggested processing of the transient response signals obtained by the two types of loading, in which these signals are integrated and multiplied by the synchronizing pulse $P_L$ as a weighting function, offers measurement possibilities similar to those offered by the widely known double correlation DLTS or DDLTS method. An advantageous difference between the two methods is that in the present invention the integration period covers the full existence of the response signal and it is not limited to discrete short time-windows as in the DDLTS technique. The application of longer integration periods result in a higher sensitivity and in a better signal to noise ratio. The considerations for the adjustment of the dead period $T_H$ described in connection with region I, are also valid in region II, since the respective recovery sections (following the moments $t_9$ and $t_{12}$) that take place after the switching transients, are weighted with opposite signs.

This method in which the respective response signals triggered by the two types of exiciting pulses are weighted with opposite signs offers a possibility for determining the spatial distribution of deep level concentration, if the duration of both types of exciting pulses $P_g$ and $P_{gm}$ are set to be equal and their relative intensity is changed.

With identical intensities and different durations the measurement output is proportional to the capture cross section ratio. Reference is made now again to Fig. 2 in which the apparatus for carrying out the method is shown.

As it was described earlier, the sample which is to be measured is connected in the measuring circuit 1. The output of the measuring circuit 1 is coupled through the gating circuit 2 to the input of the measuring unit 3 and the output of this latter is connected to the input of the transmission gate 4. The transmission gate 4 comprises a first gate 41, a track-and-hold circuit 42 with an input coupled to the output of the first gate 41 and a second gate 43 controlled inversely relative to the first gate 41. The second gate 43 has a first input coupled to the output of the track-and-hold circuit 42 and a second input coupled to the input of the first gate 41. The output of the second gate 43 delivers the response signal $S_R$ and it is coupled to the input of the synchronous detector 5.

The exciter 6 provides for the pulse-like excitation of the sample in the measuring circuit 1 in accordance with control commands delivered by the control unit 7 adapted to control and synchronize the operation of the various units of the apparatus. The clock 8 is used to deliver appropriate clock pulses to the control unit 7. An embodiment of the apparatus described heretofore is illustrated in Figs. 1 and 2 of EP—A—0041858 referred to hereinabove.

In the improvement according to the present invention a frequency divider 9 is inserted in the path between output 71 of the control unit 7 and synchronizing input 51 of the synchronous detector 5. The frequency divider 9 halves the input frequency and delivers the synchronizing pulses $P_L$ for the synchronous detector 5. The control unit 7 has an output 72 supplying the pulses $P_{Tr}$. This output 72 is coupled directly to the control input of the first gate 41 and through an inverter 10 to the control input of the second gate 43, whereby the inverted operation of the two gates is assured.

The gating circuit 2 is adapted to isolate the output of the measuring circuit 1 from the input of the measuring unit 3 for the duration $T_g$ of the excitation and for a short delay period of some nanoseconds following the excitation. This can be done e.g. by earthing the input of the measuring unit 3 and disconnecting the output line of the measuring circuit. The gating circuit 2 has a control input coupled to output 73 of the control unit 7 to receive the isolating pulses $P_i$ therefrom.

The exciter 6 comprises first and second pulse generators 61 and 62. The first pulse generator 61 has a first input 611 coupled to output 74 of the control unit 7 to receive the control pulses $P_c$ shown in Fig. 1. The first pulse generator 61 has a second inhibiting input 612 coupled to output 75 of the control unit 7 to receive the blocking pulses $P_N$. During the presence of the blocking pulses $P_N$ the first pulse generator 61 can not generate pulses.

The second pulse generator 62 is adapted to provide the second type exciting pulses $P_{gm}$, of

course in the mode of operation corresponding to region II. The second pulse generator 62 has a control input 621 coupled to output 76 of the control unit 7 to receive the second type of control pulses $P_{cm}$.

The operation of the apparatus according to the invention corresponds to the method illustrated in diagrams of Fig. 1.

A setting means not shown in the drawings provides for the appropriate setting of the parameters of the control unit 7 i.e. to operate in the first or second modes (region I or II) including the setting of the clock frequency and the duration of the exciting pulses.

If the apparatus shown in Fig. 2 is compared to conventional ones used for performing the DDLTS method, then its simple design will be apparent. The multi-channel signal processing and the several times repeated analog operations used in such known devices decreases both the signal to noise ratio and the sensitivity. Such effects can not take place in the apparatus according to the invention. According to practical tests carried out with the apparatus shown in Fig. 2, it is capable of detecting as small transient capacitance changes as $10^{-5}$ pF.

## Claims

1. A method for determining charged energy states of a sample of a semiconductor or insulator material by using deep level transient spectroscopy, comprising the steps of exciting said sample by the application of periodic exciting pulses $(P_g)$ to change the initial charge state thereof, detecting the transient response of said sample as it returns to the thermodynamical balance condition following the termination of each of said excitation pulses, blocking said detection during a blocking period $(T_T)$ defined by the occurrence of said exciting pulses $(P_g)$ and of a subsequent dead period $(T_H)$ including the recovery period of the means used for the detection, and performing a weighted integration operation on a detected response signal $(S_R)$ by the application of a symmetrical square wave synchronizing pulse $(P_L)$ as a weighting function synchronized to the frequency of said exciting pulses $(P_g)$, characterized by the steps of additionally blocking said detection for the duration of a further blocking period $(T_T)$ including a dead period and beginning at a moment $(t_4$ or $t_{10})$ defined in mid-time between the starting moments of two subsequent exciting pulses $(P_g)$, and synchronizing said synchronizing pulses $(P_L)$ to the terminating moments $(t_3, t_6, t_9, t_{12})$ of said dead periods $(T_H)$ to have a repetition period $(2T_p)$ which is equal to the repetition period of said periodic exciting pulses $(P_g)$.

2. The method as claimed in claim 1, characterized in that in said blocking periods $(T_T)$ said detected response signal $(S_R)$ is substituted by a simulated signal $(S_s)$ for said weighted integration operation which has a value equal to that of said detected response signal $(S_r)$ immediately preceding the starting moment $(t_0, t_4, t_7, t_{10})$ of said blocking period $(T_T)$.

3. The method as claimed in claim 1, in which said dead period $(T_H)$ is adjusted to be a predetermined constant portion of the repetition period of said exciting pulses $(P_g)$.

4. The method as claimed in claims 1 or 2, further characterized by the steps of exciting said sample by a second type exciting pulse $(P_{gm})$ during said further blocking periods, the second type exciting pulses $(P_{gm})$ having a different intensity and/or duration than said first exciting pulses $(P_g)$.

5. The method as claimed in claim 4, characterized in that the length of said further blocking periods is adjusted to the combined duration $(T_{Tm})$ of the second type exciting pulses $(P_{gm})$ and of the dead period $(T_H)$, and said second type exciting pulses $(P_{gm})$ are synchronized to said synchronizing pulses $(P_L)$ in such a way that the terminating moments of the dead periods $(T_H)$ following each second type exciting pulse $(P_{gm})$ coincide with moments $(t_{12})$ at which the sign of said synchronizing pulses $(P_L)$ is changed.

6. The method as claimed in any of the preceding claims, characterized in that a synchronous detector (5) is used for the weighted integration, and the synchronizing pulse $(P_L)$ forming the weighting function is coupled to a reference input of the synchronous detector (5).

7. Apparatus for carrying out the method as claimed in claim 1, comprising a measuring circuit (1) with the sample to be examined, an exciter (6) coupled to said measuring circuit, a measuring unit (3) for detecting the response of said measuring circuit, a gating circuit (2) coupled between the output of said measuring circuit and the input of said measuring unit, a transmission gate (4) coupled to the output of said measuring unit, a synchronous detector (5) with an input coupled to the output of said transmission gate, a control unit (7) and a clock (8) coupled to said control unit (7), said control unit (7) comprising outputs delivering pulses synchronized to said clock, a first of said outputs (74) being coupled to an input (611) of said exciter (6) to define exciting pulses $(P_g)$, a second output (73) being coupled to said gating circuit (2) to block the measurement during the exciting pulses and short subsequent transient periods, and a third output (72) being coupled to said transmission gate (4) to block the passage of signals therethrough during said exciting pulses and subsequent dead periods, said dead periods having a length forming a predetermined small portion of the repetition period of said exciting pulses, characterized by a frequency divider (9) with a dividing ratio of 1:2 having an input coupled to an output (71) of said control unit (7) delivering clock pulses synchronized to the end moments of said dead periods $(T_H)$ and an output coupled to a reference input (51) of said synchronous detector (5), said control unit (7) comprising an output (75) coupled to an inhibiting input (612) of said exciter (6) to block the generation of every second exciting pulse.

8. The apparatus as claimed in claim 7, characterized in that said exciter (6) comprises a first and a second pulse generator (61, 62), the first pulse generator (61) having inputs (611, 612) connected to those outputs (74, 75) of said control unit (7) which control the generation and inhibition of first type exciting pulses ($P_G$), and the second pulse generator (62) having an input (621) for triggering the generation of second type exciting pulses ($P_{gm}$) being different from the first type exciting pulses ($P_g$) which is coupled to a further output (76) of said control unit (7) to determine the occurrence of said triggering moments.

9. The apparatus as claimed in claims 7 or 8, in which said transmission gate (4) comprises a track-and-hold or a sample-and-hold circuit (42) having an input coupled to the input of said transmission gate (4) and an output which in the blocked state of the transmission gate (4) is coupled to the output thereof.

**Patentansprüche**

1. Verfahren zur Bestimmung von Ladungsenergieniveau einer Probe aus Halbleiter- oder Isoliermaterial unter Verwendung der Transient-Spektroskopie tiefer Störstellen, bei welchem die Probe mit periodischen Erregungsimpulsen ($P_g$) zur Änderung des Anfangsladungszustandes der Probe erregt wird, die Übergangsantwort der Probe beim Zurückkehren in das thermodynamische Gleichgewicht nach Beendigung jedes Erregungsimpulses abgetastet wird, das Abtasten während einer Sperrperiode ($T_T$) verhindert wird, die durch die gemeinsame Dauer der Erregungs-impulse ($P_g$) und einer darauf folgenden Totperiode ($T_H$) definiert ist, die der Erholungszeit des Meßinstrumentes einschließt, und eine gewichtete Integration eines abgetasteten Antwortsignals ($S_R$) durch Anwendung eines symmetrischen Rechteck-Synchronisierimpulses ($P_L$) als Gewichtsfunktion durchgeführt wird, der mit der Frequenz des Erregungsimpulses ($P_g$) synchronisiert ist, dadurch gekennzeichnet, daß die Abtastung zusätzlich während der Dauer einer zusätzlichen Sperrperiode ($T_T$) verhindert wird, die eine Totperiode enthält und zu einem Zeitpunkt ($t_4$ oder $t_{10}$) anfängt, der in der Zeitmitte zwischen den Anfangszeitpunkten zweier aufeinanderfolgender Erregungsimpulse ($P_g$) definiert ist, und daß die Synchronisierimpulse ($P_L$) zu den Endzeitpunkten ($t_3$, $t_6$, $t_9$, $t_{12}$) der Totperioden ($T_H$) derart synchronisiert werden, daß sie eine Wiederholungsperiode ($2T_p$) haben, die gleich der Wiederholungsperiode der periodischen Erregungsimpulse ($P_g$) ist.

2. Verfahren nach Anspruch 1, dadurch gekennzeichnet, daß das Antwortsignal ($S_R$) in den Sperrperioden ($T_T$) für die gewichtete Integration durch ein simuliertes Signal ($S_S$) ersetzt wird, das den Wert des unmittelbar vor dem Anfangszeitpunkt ($t_0$, $t_4$, $t_7$, $t_{10}$) der Sperrperiode ($T_T$) abgetasteten Antwortsignals ($S_R$) hat.

3. Verfahren nach Anspruch 1, bei welchem die Totperiode ($T_H$) als vorgegebener konstanter Anteil der Wiederholungsperiode der Erregungsimpulse ($P_g$) eingestellt ist.

4. Verfahren nach Anspruch 1 oder 2, dadurch gekennzeichnet, daß die Probe während den zusätzlichen Sperrperioden mit Erregungsimpulsen ($P_{gm}$) einer zweiten Art angeregt wird, wobei die Erregungsimpulse ($P_{gm}$) zweiter Art gegenüber den ersten Erregungsimpulsen ($P_g$) eine unterschiedliche Intensität und/oder Dauer aufweisen.

5. Verfahren nach Anspruch 4, dadurch gekennzeichnet, daß die Dauer der zusätzlichen Sperrperioden auf die Gesamtdauer ($T_{Tm}$) der Erregungsimpulse ($P_{gm}$) zweiter Art und der Totperiode ($T_H$) eingestellt ist und daß die Erregungsimpulse ($P_{gm}$) der zweiten Art mit den Synchronisierimpulsen ($P_L$) derart synchronisiert sind, daß die Endzeitpunkte der Totperioden ($T_H$), die jedem Erregungsimpuls ($P_{gm}$) zweiter Art folgen, mit dem Zeitpunkten ($t_{12}$) zusammenfallen, an denen sich das Vorzeichen der Synchronisierimpulse ($P_L$) ändert.

6. Verfahren nach einem der vorherigen Ansprüche, dadurch gekennzeichnet, daß ein Synchrondetektor (5) für die gewichtete Integration verwendet wird, und der Synchronisierimpuls ($P_L$), der die Gewichtsfunktion bildet, an einen Referenzeingang des Synchrondetektors (5) angeschlossen ist.

7. Vorrichtung zur Durchführung des Verfahrens nach Anspruch 1 mit einer Meßschaltung (1) mit der zu untersuchenden Probe, einem an die Meßschaltung angeschlossenen Erreger (6), einer Meßeinheit (3) zum Abtasten der Antwort der Meßschaltung, einer Gatterschaltung (2) die zwischen den Ausgang der Meßschaltung und den Eingang der Meßeinheit geschaltet ist, einem Durchlaßgatter (4), das an den Ausgang der Meßeinheit angeschlossen ist, einem Synchrondetektor (5), dessen Eingang an den Ausgang des Durchlaßgatters angeschlossen ist, einer Steuereinheit (7) und einen daran angeschlossenen Zeitgeber (8), wobei die Steuereinheit Ausgänge enthält, die mit dem Zeitgeber synchronisierte Impulse liefern, und der erste (74) dieser Ausgänge an einen Eingang (611) des Erregers (6) angeschlossen ist, um Erregungsimpulse ($P_g$) zu definieren, ein zweiter Ausgang (73) an die Gatterschaltung (2) zum Sperren der Messung während des Auftretens der Erregungsimpulse und darauf folgender kurzer Übergangsperioden angeschlossen ist, und ein dritter Ausgang (72) an das Durchlaßgatter (4) zum Sperren des Durchgangs von Signalen während des Vorliegens der Erregungsimpulse und der darauf folgenden Totperioden angeschlossen ist, die eine Dauer haben, die einen vorbestimmten Anteil der Wiederholungsperiode der Erregungsimpulse ausmacht, gekennzeichnet durch einen Frequenzteiler (9) mit einem Teilverhältnis von 1:2, der einen Eingang, welcher an den Ausgang (71) der Steuereinheit (7) angeschlossen ist, welcher Zeitgeberimpulse liefert, die mit den Endzeitpunkten der Totperioden ($T_H$) synchronisiert sind, und einen Ausgang aufweist, der an den Referenzeingang (51) des Synchrondetektors (5) angeschlossen ist, wobei die Steuereinheit (7) einen Ausgang (75) enthält, der an einen Sperreingang (612) des Erregers (6) zur Verhinderung der Erzeugung jedes zweiten Erregungsimpulses angeschlossen ist.

8. Vorrichtung nach Anspruch 7, dadurch gekennzeichnet, daß der Erreger (6) einen ersten und einen zweiten Impulsgenerator (61, 62) enthält, wobei der erste Impulsgenerator (61) Eingänge (611, 612) aufweist, die an diejenigen Ausgänge (74, 75) der Steuereinheit (7) angeschlossen sind, die die Erzeugung und Verhinderung von Erregungsimpulsen ($P_g$) einer ersten Art steuern, und der zweite Impulsgenerator (62) zum Auslösen von Erregungsimpulsen ($P_{gm}$) einer zweiten Art, die von den Erregungsimpulsen ($P_g$) der ersten Art verschieden sind, einen Eingang (621) aufweist, der an einen weiteren Ausgang (76) der Steuereinheit (7) zur Bestimmung des Auftretens der Auslöse-Zeitpunkte angeschlossen ist.

9. Vorrichtung nach Anspruch 7 oder 8, bei welcher das Durchlaßgatter (4) eine track-and-hold- oder sample-and-hold-Speicherschaltung (42) enthält, die einen Eingang, der an den Eingang des Durchlaßgatters (4) angeschlossen ist, und einen Ausgang aufweist, der während des Sperrzustandes des Durchlaßgatters (4) an dessen Ausgang angeschlossen ist.

**Revendications**

1. Un procédé de détermination des états de charge en énergie d'un échantillon d'une matière semi-conductrice ou isolante par utilisation de la méthode de spectroscopie transitoire de niveaux de profondeur, comprenant les étapes consistant à exciter ledit échantillon par application d'impulsions d'excitation périodiques ($P_g$) afin de changer son état de charge initial, à détecter la réponse transitoire dudit échantillon quand il revient dans la condition d'équilibre thermodynamique après terminaison de chacune desdites impulsions d'excitation à bloquer ladite détection pendant une période de blocage ($T_T$) définie par l'apparition desdites impulsions d'excitation ($P_g$) et d'une période morte consécutive ($T_H$) comprenant la période de récupération du moyen utilisé pour la détection, et à effectuer une opération d'intégration pondérée sur une signal de réponse détecté ($S_R$) par l'application d'une impulsion de synchronisation d'ondes carrées symétriques ($P_L$) sous la forme d'une fonction de pondération synchronisée sur la fréquence desdites impulsions d'excitation ($P_g$), caractérisé par les étapes consistant à bloquer additionnellement ladite détection pendant la durée d'une autre période de blocage ($T_T$) comprenant une période morte et commençant à un moment ($t_4$ ou $t_{10}$) à mi-temps entre les moments de génération de deux impulsions d'excitation successives ($P_g$), et à synchroniser lesdites impulsions de synchronisation ($P_L$) avec les moments de terminaison ($t_3$, $t_6$, $t_9$, $t_{12}$) desdites périodes mortes ($T_H$) afin d'obtenir une période de répétition ($2T_p$) qui est égale à la période de répétition desdites impulsions d'excitation périodiques ($P_g$).

2. Le procédé tel que revendiqué dans la revendication 1, caractérisé en ce que, dans lesdites périodes de blocage ($T_T$), ledit signal de réponse détecté ($S_R$) est remplacé par un signal simulé ($S_s$) pour ladite opération d'intégration pondérée, qui a une valeur égale à celle dudit signal de réponse détecte ($S_R$) immédiatement avant le moment de départ ($t_0$, $t_4$, $t_7$, $t_{10}$) de ladite période de blocage ($T_T$).

3. Le procédé tel que revendiqué dans la revendication 1, dans lequel ladite période morte ($T_H$) est réglée de façon à correspondre à une proportion constante prédéterminée de la période de répétition desdites impulsions d'excitation ($P_g$).

4. Le procédé tel que revendiqué dans la revendications 1 ou 2, caractérisé en outre par les étapes consistant à exciter ledit échantillon par une impulsion d'excitation de second type ($P_{gm}$) pendant lesdites autres périodes de blocage, les impulsions d'excitation de second type ($P_{gm}$) ayant une intensité et/ou une durée différente de celles desdites premières impulsions d'excitation ($P_g$).

5. Le procédé tel que revendiqué dans la revendication 4, caractérisé en ce que la longueur desdites autres périodes de blocage est réglée sur la somme de la durée ($T_{Tm}$) des impulsions d'excitation de second type ($P_{gm}$) et de la période morte ($T_H$), lesdites impulsions d'excitation de second type ($P_{gm}$) étant synchronisées avec lesdites impulsions de synchronisation ($P_L$), d'une manière telle que les moments de terminaison des périodes mortes ($T_H$) suivant chaque impulsion d'excitation de second type ($P_{gm}$) coïncident avec les instants ($t_{12}$) où le signe desdites impulsions de synchronisation ($P_L$) est changé.

6. Le procédé tel que revendiqué dans l'une quelconque des revendications précédentes, caractérisé en ce qu'un détecteur synchrone (5) est utilisé pour l'intégration pondérée et l'impulsion de synchronisation ($P_L$) remplissant la fonction de pondération est appliqué à une entrée de référence du détecteur synchrone (5).

7. Appareil pour la mise en oeuvre du procédé tel que revendiqué dans la revendication 1, comprenant un circuit de mesure (1) avec l'échantillon à examiner, un excitateur (6) relié audit circuit de mesure, un dispositif de mesure (3) pour détecter la réponse dudit circuit de mesure, un circuit de distribution (12) branché entre la sortie dudit circuit de mesure et l'entrée dudit dispositif de mesure, une porte de transmission (4) reliée à la sortie dudit dispositif de mesure, un détecteur synchrone (5) comportant une entrée reliée à la sortie de ladite porte de transmission, une unité de commande (7) et une horloge (8) reliée à ladite unité de commande (7), ladite unité de commande (7) comprenant des sorties produisant des impulsions synchronisées avec ladite horloge, une première desdites sorties (74) étant reliée à une entrée (611) dudit excitateur (6) pour former des impulsions d'excitation ($P_g$), une seconde sortie (73) étant reliée audit circuit de distribution (2) pour arrêter la mesure pendant les impulsions d'excitation et pendant de courtes périodes transitoires consécutives, et une troisième sortie (72) reliée à ladite porte de transmission (4) pour empêcher le passage de signaux dans celle-ci pendant la durée desdites impulsions d'excitation et pendant des périodes mortes consécutives, lesdites périodes mortes ayant une durée correspondant à une petite proportion prédéterminée de la période de répétition desdites impulsions d'excitation, caractérisé par un diviseur de fréquence (9) ayant un rapport de division de 1/2 et comportant une entrée reliée à une sortie (71) de ladite unité de commande (7) fournissant des impulsions d'horloge synchronisées avec les moments de terminaison desdites périodes mortes ($T_H$), ainsi qu'une sortie reliée à une entrée de référence (51) dudit détecteur synchrone (5), ladite unité de commande (7) comprenant une sortie (75) reliée à une entrée d'inhibition (612) dudit excitateur (6) pour empêcher la génération d'une impulsion d'excitation sur deux.

8. Le dispositif tel que revendiqué dans la revendication 7, caractérisé en ce que ledit excitateur (6) comprend un premier et un second générateurs d'impulsions (61, 62), le premier générateur d'impulsions (61) comportant des entrées (611, 612) reliées aux sorties (74, 75) de ladite unité de commande (7) qui commande la génération et l'inhibition des impulsions d'excitation de premier type ($P_G$) et le second générateur d'impulsions (62) comportant une entrée (621) servant à déclencher la génération d'impulsions de second type ($P_{gm}$) qui sont différentes des impulsions d'excitation du premier type ($P_g$), ce second générateur étant relié à une autre sortie (76) de ladite unité de commande (7) pour déterminer l'apparition desdits instants de déclenchement.

9. Le dispositif tel que revendiqué dans les revendications 7 ou 8, dans lequel ladite porte de transmission (4) comprend un circuit de poursuite-et-maintien ou un circuit d'échantillonnage-et-maintien (42) comportant une entrée reliée à l'entrée de ladite porte de transmission (4) et une sortie qui, dans l'état bloqué de la porte de transmission (4), est reliée à sa sortie.

Fig. 1

Fig.2